# EUROPÄISCHE PATENTSCHRIFT

(11) **EP 3 764 544 B1**
(45) Veröffentlichungstag und Bekanntmachung des Hinweises auf die Patenterteilung: **20.12.2023**
(21) Anmeldenummer: 20180012.5
(22) Anmeldetag: 15.06.2020
(51) Int. Cl.: H03K 17/96

(54) **BEDIENEINRICHTUNG FÜR EIN ELEKTROGERÄT UND ELEKTROGERÄT MIT EINER SOLCHEN BEDIENEINRICHTUNG**
OPERATING DEVICE FOR AN ELECTRICAL DEVICE AND ELECTRICAL DEVICE WITH SUCH AN OPERATING DEVICE
DISPOSITIF DE COMMANDE D'UN APPAREIL ÉLECTRIQUE ET APPAREIL ÉLECTRIQUE DOTÉ D'UN TEL DISPOSITIF DE COMMANDE

(30) Priorität: 12.07.2019 DE 102019210350
(43) Veröffentlichungstag der Anmeldung: 13.01.2021
(73) Patentinhaber: E.G.O. Elektro-Gerätebau GmbH, 75038 Oberderdingen (DE)
(72) Erfinder: Merz, Holger, 75038 Oberderdingen (DE); Schmid, Dennis, 76703 Kraichtal (DE)
(74) Vertreter: Patentanwälte Ruff, Wilhelm, Beier, Dauster & Partner mbB

(56) Entgegenhaltungen:
- EP-A1- 2 341 624
- EP-A1- 3 065 299
- WO-A1-2018/078175
- DE-A1-102015 015 927
- US-A1- 2016 301 411

## Beschreibung

Die Erfindung betrifft eine Bedieneinrichtung für ein Elektrogerät sowie ein Elektrogerät, das eine derartige Bedieneinrichtung aufweist.

Aus der EP 1 257 057 A1 ist eine Bedieneinrichtung mit einem Sensorelement für einen kapazitiven Berührungsschalter bekannt. Dort ist ein trichterförmig umlaufendes Lichtleitmittel über einer LED auf einer Leiterplatte vorgesehen, das von einer elektrisch leitfähigen Sensorfläche überdeckt wird. Diese Sensorfläche liegt an der Unterseite einer Kochfeldplatte als Berührfläche an. Eine elektrische Kontaktierung erfolgt über einen daneben verlaufenden Stift oder dadurch, dass das Lichtleitmittel elektrisch leitfähig ist

Aus der EP 3 179 633 A1 ist eine weitere Bedieneinrichtung für ein Kochfeld bekannt, die ähnlich ausgebildet ist. Oben auf einem umlaufenden Hohlkörper, der um eine LED auf einer Leiterplatte herum vorgesehen ist und der elektrisch leitfähig ist, ist eine elektrisch leitfähige Sensorplatte vorgesehen. Diese bildet einen kapazitiven Berührungsschalter an der Oberseite der Kochfeldplatte.

Aus der EP 3 065 299 A1 ist eine Bedieneinrichtung für ein Elektro-Haushaltsgerät bekannt, wobei auf einem Bauteilträger unterhalb einer Bedienblende mehrere kapazitive Berührungsschalter gebildet sind. Auf dem Bauteilträger sind mehrere Schraubenfedern angeordnet, die einen flachen Sensorelementkörper tragen, der von unten an die Bedienblende angedrückt ist. Der Sensorelementkörper besteht dabei aus elektrisch leitfähigem elastischem Material. Nahe der Schraubenfedern können LED angeordnet sein, die nach oben durch den Sensorelementkörper und die Bedienblende hindurch strahlen können.

Aus der EP 2 341 624 A1 ist ein kapazitiver Berührungsschalter für beispielsweise ein Kochfeld bekannt, wobei ebenfalls eine Schraubenfeder auf einem Bauteilträger aufliegt. Die Schraubenfeder liegt an der Unterseite einer elektrisch isolierenden Abdeckplatte als Bedienblende an und bildet im oberen Bereich als elektrisch leitfähiger Hohlkörper ein kapazitives Sensorelement für den kapazitiven Berührungsschalter. Gemäß einem Ausführungsbeispiel ist ein lichtleitender Führungskörper oben an der Schraubenfeder mit einem umlaufenden größeren Kragen als Erweiterung oben an der Schraubenfeder angeordnet. Dieser Führungskörper ist aus elektrisch isolierendem Material gefertigt. Eine Befestigung der Schraubenfeder auf dem Bauteilträger ist nicht näher erläutert.

Aus der US 2016/03031411 A1 ist eine weitere Bedieneinrichtung für beispielsweise einen Ofen oder ein sonstiges Elektro-Haushaltsgerät bekannt mit einer lichtdurchlässigen Bedienblende, unter der unter anderem ein Abstandsbauteil angeordnet ist, das gitterartig in mehrere Bereiche unterteilt ist. Jeder dieser Bereiche kann mittels eines Leuchtmittels auf einem Bauteilträger einzeln beleuchtet werden. Auf dieses gitterartige Abstandsbauteil ist ein flächiger dünner Träger aufgelegt, der mehrere kapazitive Sensorelemente bildet. So können an der Bedieneinrichtung beleuchtete Flächen geschaffen werden, die möglicherweise ein beleuchtetes Symbol anzeigen und jeweils mit einem kapazitiven Sensorelement unterlegt sind. So kann eine jeweilige Bedienung genau erkannt werden.

Aus der WO 2018/078175 A1 ist eine nochmals weitere Bedieneinrichtung bekannt mit einem Bauteilträger und einer Bedienblende, wobei dazwischen ein kapazitiver Berührungsschalter gebildet wird, und zwar hauptsächlich von einem Lichtleitelement über einer LED. Unterhalb des Lichtleitelements sind auf dem Bauteilträger kapazitive Elektroden für den kapazitiven Berührungsschalter vorgesehen.

### Aufgabe und Lösung

Der Erfindung liegt die Aufgabe zugrunde, eine eingangs genannte Bedieneinrichtung sowie ein damit versehenes Elektrogerät zu schaffen, mit denen Probleme des Standes der Technik vermieden werden können und es insbesondere möglich ist, eine vorteilhafte Möglichkeit zur einfachen Ausgestaltung und einfachen sowie praxistauglichen Montage der Bedieneinrichtung zu schaffen.

Gelöst wird diese Aufgabe durch eine Bedieneinrichtung mit den Merkmalen des Anspruchs 1 sowie durch ein Elektrogerät mit den Merkmalen des Anspruchs 14. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät genannt. Sie sollen jedoch unabhängig davon sowohl für die Bedieneinrichtung als auch für das Elektrogerät selbstständig und unabhängig voneinander gelten können. Der Wortlaut der Ansprüche wird durch ausdrückliche Bezugnahme zum Inhalt der Beschreibung gemacht.

Es ist vorgesehen, dass die Bedieneinrichtung für das Elektrogerät einen Bauteilträger sowie eine Bedienblende aufweist, die mit Abstand zueinander angeordnet sind, vorteilhaft parallel zueinander. Der Bauteilträger kann durch eine Leiterplatte gebildet sein. Im Falle eines Kochfelds als Elektrogerät kann die Bedienblende durch eine übliche Kochfeldplatte gebildet sein, wie dies an sich bekannt ist. Alternativ kann es auch eine beliebige Außenseite eines Elektrogeräts sein, an der mittels Berührungsschaltern auf an sich übliche Art und Weise eine Bedienung des Elektrogeräts erfolgt. Die Bedieneinrichtung weist auch mindestens einen kapazitiven Berührungsschalter auf, der an der Bedienblende eine Berührfläche bildet bzw. aufweist. Hier kann durch übliche Art und Weise das Auflegen eines Fingers auf die Berührfläche kapazitiv erkannt werden und als Betätigung oder Bedienung gewertet und verwendet werden. Für den kapazitiven Berührungsschalter weist die Bedieneinrichtung einen elektrisch leitfähigen Sensorelementkörper auf, wobei der Sensorelementkörper auf den Bauteilträger aufgesetzt ist und daran elektrisch kontaktiert ist. Der Sensorelementkörper kann elastisch sein, muss dies aber nicht. Oben auf dem Sensorelementkörper ist eine elektrisch isolierende Abdeckung vorgesehen bzw. angeordnet. Die Abdeckung überdeckt den Sensorelementkörper in der Projektion von oben vollständig. Die Abdeckung ist mit ihrer Oberseite zu einer Unterseite der Bedienblende hin angeordnet, weist also auf diese zu bzw. liegt mit der Oberseite an der Unterseite der Bedienblende an. Besonders vorteilhaft wird ein solches Anliegen angesehen, da dann eine definierte Zuordnung des Sensorelementkörpers zu der Bedienblende und der daran ausgebildeten Berührfläche vorgesehen ist, was für kapazitive Berührungsschalter bekanntermaßen sehr vorteilhaft ist für eine exakte Funktion.

Somit kann mit der Erfindung erreicht werden, dass ein kapazitiver Berührungsschalter gebildet wird mittels eines geeigneten Sensorelementkörpers, dieser Sensorelementkörper aber noch einmal überdeckt ist bzw. abgedeckt ist. So kann er beispielsweise nicht direkt an der Unterseite der Bedienblende anliegen mit der Gefahr einer möglichen Beschädigung. Des Weiteren ist es möglich, eine verbesserte elektrische Isolierung zwischen der Berührfläche und dem Sensorelementkörper bzw. dem Bauteilträger oder einer damit verbundenen elektrischen Schaltung zu schaffen.

Bei der Erfindung ist der Bedienelementkörper auf ein Kontaktfeld auf dem Bauteilträger aufgesetzt, um elektrisch kontaktiert zu werden. Dies kann ein übliches Kontaktfeld nach Art einer verbreiterten Leiterbahn oder verbunden mit einer solchen Leiterbahn sein, vorteilhaft verzinnt für eine bessere elektrische Verbindung. Sowohl eine elektrische Kontaktierung als auch eine Befestigung kann durch die Verwendung von sogenanntem elektrisch leitfähigem Leitkleber verbessert werden, mit dem der Sensorelementkörper mit dem Kontaktfeld verklebt wird. Dies kann auch automatisiert erfolgen, vorteilhaft im Rahmen einer automatisierten bzw. SMD-Bestückung des Bauteilträgers mit einem oder mehreren Sensorelementkörpern. Ein gewöhnlicher SMD-Kleber, der nicht elektrisch leitfähig ist, kann ausreichen. Die elektrische Kontaktierung kann dann durch klebfreies Aufliegen des Sensorelementkörpers auf dem Kontaktfeld und einen Anpressdruck sichergestellt werden.

In vorteilhafter Ausgestaltung der Erfindung besteht der Sensorelementkörper aus einem Vollmaterial, welches selbst elektrisch leitfähig ist, es bedarf also nicht extra einer leitfähigen Beschichtung des Sensorelementkörpers. Das Material des Sensorelementkörpers weist vorteilhaft keine Lufteinschlüsse auf, ist also kein geschäumtes Material. Dabei weist der Sensorelementkörper insgesamt einen spezifischen elektrischen Widerstand auf, der darauf abgestimmt sein kann, bestimmte elektrische Eigenschaften aufzuweisen, die für eine besonders gute Funktion der Bedieneinrichtung von Vorteil sind. Das Material des Sensorelementkörpers ist vorteilhaft elastisch, insbesondere derart, dass es etwas zusammengedrückt werden kann bzw. dass es die Abdeckung obendrauf permanent und zuverlässig an die Unterseite der Bedienblende andrücken kann.

Bei der Erfindung sind auf dem Bauteilträger, der insbesondere der einzige Bauteilträger bzw. die einzige Leiterplatte der Bedieneinrichtung ist, mehrere gleiche bzw. gleichartige Sensorelementkörper angeordnet. Jeder dieser Sensorelementkörper kann dann einen eigenen kapazitiven Berührungsschalter bilden. Vorteilhaft sind die Sensorelementkörper identisch, wodurch Herstellungsaufwand eingespart werden kann. Dabei können mehrere identische Sensorelementkörper auf dem Bauteilträger angeordnet sein, unter Umständen können auch alle Sensorelementkörper identisch sein. Alternativ können sie jeweils gleichen Konstruktionsprinzipien folgen, aber beispielsweise für eine Darstellung jeweils unterschiedlicher Leuchtanzeigen ausgebildet sein.

Bei der Erfindung ist der Sensorelementkörper als Hohlkörper ausgebildet, insbesondere als Hohlzylinder. Ein innerer Hohlraum erstreckt sich dann durch den Sensorelementkörper hindurch von einem Ende bis zum anderen, also in Richtung von dem Bauteilträger hin zu der Bedienblende, so dass er beispielsweise auch einen Lichtleitkanal bilden kann, wie es an sich aus dem eingangs genannten Stand der Technik bekannt ist. Die Form des inneren Hohlraums kann dabei entlang seines Verlaufs variieren, bevorzugt ist er aber zylindrisch ausgebildet und weist somit gleichbleibenden Querschnitt auf. Dann ist eine Herstellung vereinfacht, beispielsweise durch ein Extrudierverfahren für ein längliches Profil, von dem einzelne Sensorelementkörper abgeschnitten werden können. In dem inneren Hohlraum ist erfindungsgemäß ein Leuchtmittel auf dem Bauteilträger angeordnet. Ein solches Leuchtmittel ist vorteilhaft eine LED, besonders vorteilhaft eine SMD-LED für eine leichtere Herstellung und beispielsweise auch eine SMD- bzw. automatisierte Bestückung des Bauteilträgers.

Ein Querschnitt des Hohlraums entlang seiner Erstreckung kann vorteilhaft so sein wie die Außenform des Sensorelementkörpers ist, so dass es eben ein zylindrischer Sensorelementkörper ist. Eine runde Form bietet sich hier an.

In Ausgestaltung der Erfindung ist die Abdeckung dadurch elektrisch isolierend, dass sie aus elektrisch isolierendem Material besteht. Sie besteht vorteilhaft aus einem Silikon und ist damit elektrisch isolierend sowie auch wärmebeständig, was vor allem dann von Vorteil ist, wenn das Elektrogerät ein Kochgerät bzw. ein Kochfeld ist und die Bedienblende eine Kochfeldplatte. Bevorzugt verläuft die Abdeckung über mehreren oder über sämtlichen Sensorelementkörpern der Bedieneinrichtung bzw. eines Bauteilträgers. Dadurch werden eine Montage sowie vor allem eine ortsgenaue Platzierung stark vereinfacht.

Eine Dicke der Abdeckung kann zwischen 1 mm und 10 mm betragen, wodurch ihre vorgenannten wichtigen Funktionen sichergestellt werden können. So kann sie beispielsweise an der dünnsten Stelle zwischen 1 mm und 4 mm dick sein, wodurch sowohl ein mechanischer Zusammenhalt als auch eine vorgenannte elektrische Isolierung ausreichend gewährleistet sind. Besonders dünn kann die Abdeckung beispielsweise dort sein, wo sie sozusagen zwischen Sensorelementkörper und Bedienblende verläuft. Somit ist die Oberseite des Sensorelementkörpers, die eine Sensorfläche für den kapazitiven Berührungsschalter bildet, dann möglichst nahe an der Unterseite der Bedienblende bzw. somit auch an der Oberseite der Bedienblende, wo eben die genannte Berührfläche liegt. Die Dicke der Abdeckung kann auch bereichsweise variieren, dies wird nachfolgend noch näher erläutert.

Bei der Erfindung ist die Abdeckung zumindest in dem Bereich über dem vorgenannten inneren Hohlraum lichtdurchlässig. So kann das Licht von einem darin angeordneten Leuchtmittel durch die Abdeckung hindurch und durch die dann ebenfalls lichtdurchlässig ausgebildete Bedienblende nach oben strahlen für eine an sich bekannte Leuchtanzeige. Die Abdeckung kann bereichsweise lichtdurchlässig sein bzw. aus lichtdurchlässigem Material bestehen. Vorteilhaft besteht sie insgesamt aus lichtdurchlässigem Material, wofür sich eben auch ein vorgenanntes Silikon anbietet.

In bevorzugter Ausgestaltung der Erfindung ist die Abdeckung nicht vollständig lichtdurchlässig bzw. ist sie nur bereichsweise lichtdurchlässig, besonders bevorzugt über den genannten Hohlräumen, da hier eben eine Lichtdurchlässigkeit notwendig ist. Eine vollständige Lichtdurchlässigkeit kann aber als nachteilig angesehen werden, da dann einfach nur unbestimmte Lichterscheinungen bzw. unvorteilhafte Leuchtanzeigen entstehen würden. Zu diesem Zweck kann die Abdeckung nur eine Lichtdurchlässigkeit in genauer Form aufweisen, was vorteilhaft dadurch erreicht werden kann, dass sie mit einer lichtundurchlässigen Beschichtung versehen ist. Eine solche lichtundurchlässige Beschichtung kann grundsätzlich an der Unterseite oder an der Oberseite vorgesehen sein, wobei eine lichtundurchlässige Beschichtung an der Oberseite den Vorteil aufweist, dass dann eine Kontur einer dadurch erzeugten Leuchtanzeige erheblich schärfer wirkt für eine Bedienperson. Dies wird als vorteilhaft angesehen. Eine lichtundurchlässige Beschichtung ist besonders bevorzugt eine Ausnehmung in Form eines oder mehrerer Symbole, Zeichen oder Buchstaben, die dann oberhalb des inneren Hohlraums mit dem Leuchtmittel darin angeordnet sind. Durch diese mindestens eine Ausnehmung über dem Hohlraum kann Licht von einem darin angeordneten Leuchtmittel somit in die Abdeckung hinein und durch die Abdeckung hindurch strahlen. Dies ist grundsätzlich auch in etwas anderer Ausgestaltung aus dem vorgenannten Stand der Technik bekannt, um eine Leuchtanzeige zu bewirken.

Um bei relativ nahe nebeneinander angeordneten Sensorelementkörpern mit jeweils einem Hohlraum und einem Leuchtmittel darin ein seitliches Überstrahlen mit ungewünschten Leuchtanzeigen oder Leuchterscheinungen zu vermeiden, kann vorgesehen sein, die Abdeckung an der Oberseite der Sensorelementkörper verdünnt relativ dünn auszugestalten, beispielsweise wie zuvor beschrieben. Dann wird Licht nur in sehr geringem Maße, falls überhaupt, seitlich weitergeleitet. Erfindungsgemäß reicht die Abdeckung mit einem Vorsprung nach unten in den inneren Hohlraum des Sensorelementkörpers hinein. Dieser Vorsprung passt dabei besonders vorteilhaft formschlüssig in den inneren Hohlraum, so dass seine Form zu der Form bzw. zu dem Querschnitt des inneren Hohlraums korrespondiert. Der Vorsprung kann dabei bis kurz vor ein Leuchtmittel unten im Hohlraum reichen, ein Abstand kann sehr gering sein, beispielsweise bis zu 0,1 mm, um Maßtoleranzen noch ausgleichen zu können ohne Berührung. Ein solcher Vorsprung aus lichtdurchlässigem Material der Abdeckung weist zusätzlich noch den Vorteil auf, dass dann eine sehr gute Lichteinkopplung in die Abdeckung hinein und somit Durchstrahlung durch die Abdeckung hindurch erreicht wird. Probleme mit zu viel Verlust von Leuchtstärke durch seitliches Abstrahlen des Leuchtmittels können dadurch reduziert werden. Ist das Licht einmal in das Material der Abdeckung bzw. in den lichtleitenden Vorsprung hineingekoppelt, so wird es nicht oder nur in geringem Maß an dessen Außenseiten wieder austreten aufgrund von Reflexion. Des Weiteren können die vorgenannten Vorsprünge auch dazu dienen, dass die Sensorelementkörper und die Abdeckung, insbesondere deren Ausnehmungen an einer lichtundurchlässigen Beschichtung, genau ihre Position zueinander behalten.

Alternativ oder zusätzlich kann vorgesehen sein, dass Innenwände des inneren Hohlraums zumindest teilweise reflektierend beschichtet oder mit einer reflektierenden Beschichtung versehen sind. Dies sollte zumindest im unteren Bereich der Fall sein. Hierfür bietet sich beispielsweise reflektierende Farbe oder eine Hülse mit einer Form entsprechend dem inneren Hohlraum aus reflektierendem Material an. Damit wird möglichst viel von dem Licht des Leuchtmittels nach oben in die Abdeckung hineingestrahlt.

Eine Abdeckung kann grundsätzlich beliebige Form aufweisen oder so verlaufen, dass sie sämtliche Sensorelementkörper des Bauteilträgers oder der Bedieneinrichtung überdeckt und nur geringfügig seitlich übersteht, beispielsweise einige m bis einige cm. Alternativ kann die Abdeckung auch eine rechteckige Form aufweisen, wodurch sie möglicherweise leichter gehandhabt werden kann.

Eine Höhe der Sensorelementkörper kann einige mm betragen, vorteilhaft zwischen 3 mm und 20 mm. Dann ist darin ausreichend Platz für einen genannten Hohlraum samt Leuchtmittel vorgesehen. Des Weiteren ist der Weg bis zur Unterseite der Bedienblende nicht zu lang.

Bei einem erfindungsgemäßen Elektrogerät kann eine vorbeschriebene Bedieneinrichtung derart vorgesehen sein, dass die Bedienblende eine Vorderfront oder eine Abdeckung bzw. eine Außenseite oder eine Außenwand des Elektrogeräts zumindest teilweise bildet. Vorteilhaft ist die Bedienblende an der Vorderseite oder an der Oberseite angeordnet, besonders vorteilhaft im vorderen Bereich der Oberseite. Die Bedienblende kann möglicherweise so ausgebildet sein, dass sie undurchbrochen ist bzw. keine Durchbrüche aufweist. Dadurch ist sie optisch geschlossen und mechanisch stabiler sowie vor allem wasserdicht sowie weniger anfällig für Verschmutzungen. Vorteilhaft ist das Elektrogerät dabei ein Elektrokochgerät wie beispielsweise ein Backofen oder ein Kochfeld.

Ist das Elektrogerät ein Backofen, so ist die Bedienblende an einer oberen Vorderfront vorgesehen, vorteilhaft als von rechts nach links durchgehender Streifen. Die kapazitiven Berührungsschalter dienen zur Bedienung des Backofens, wobei die Berührungsschalter durch beleuchtbare Symbole entsprechend gekennzeichnet sind.

Ist das Elektrogerät ein Kochfeld, so weist es eine Kochfeldplatte auf, von der ein Teil die Bedienblende bildet. Dabei liegt bevorzugt die Abdeckung mit ihrer Oberseite an der Unterseite der Kochfeldplatte an, welche die Bedienblende bildet. An der Oberseite der Kochfeldplatte sind dann in diesem Bereich die kapazitiven Berührungsschalter mit Berührfläche gebildet. Auf mechanische Schalter odgl. kann dann leicht verzichtet werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schnittdarstellung durch eine erfindungsgemäße Bedieneinrichtung, die in ein erfindungsgemäßes Kochfeld integriert ist,
- Fig. 2: eine Draufsicht auf einen Sensorelementkörper der Bedieneinrichtung aus Fig. 1,
- Fig. 3: eine Schrägansicht auf einen Schnitt durch eine leicht abgewandelte Bedieneinrichtung ähnlich Fig. 1 und
- Fig. 4: eine Schnittdarstellung durch eine nicht zur Erfindung gehörende Bedieneinrichtung ähnlich Fig. 1.

### Detaillierte Beschreibung der Ausführungsbeispiele

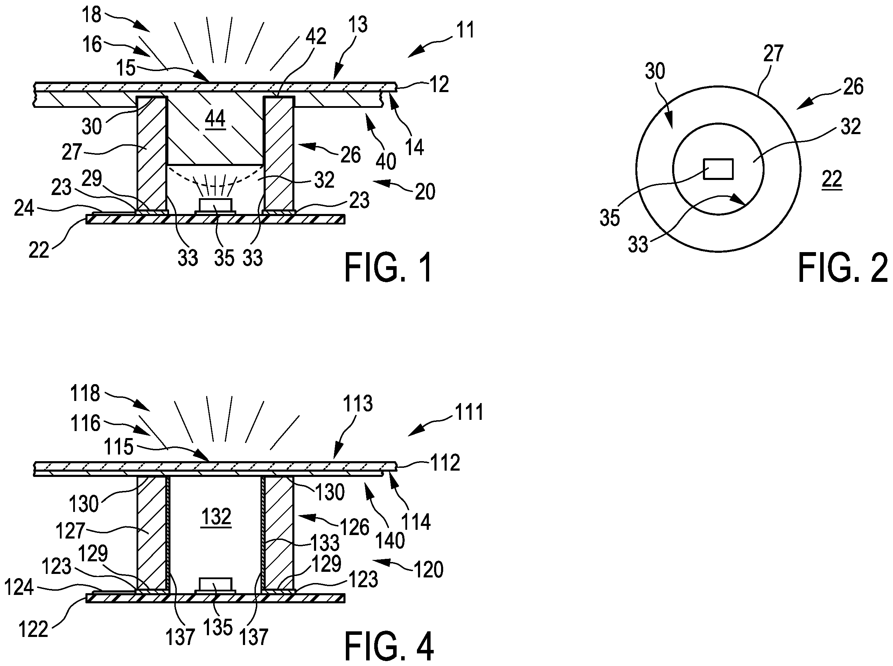

in der Fig. 1 ist in Schnittdarstellung ein erfindungsgemäßes Kochfeld 11 dargestellt, in welches eine erfindungsgemäße Bedieneinrichtung 20 integriert ist. Das Kochfeld 11 ist an sich üblich ausgebildet mit einer Kochfeldplatte 12, die eine Oberseite 13 und eine Unterseite 14 aufweist. Die Kochfeldplatte 12 besteht vorteilhaft aus Glaskeramik. Darunter bzw. an der Unterseite 14 anliegend sind vorteilhaft noch Heizeinrichtungen vorgesehen, die hier aber nicht dargestellt sind. Der sonst notwendige Aufbau für das Kochfeld 11 ist aber sehr leicht vorstellbar.

An der Kochfeldplatte 12 ist an deren Oberseite 13 eine Berührfläche 15 gebildet, die einen kapazitiven Berührschalter 16 ergibt. Auf die Berührfläche 15 bzw. auf den Berührschalter 16 kann eine Bedienperson den Finger legen, was dann kapazitiv erkannt wird auf übliche Art und Weise für eine Schaltfunktion bzw. für eine Bedienfunktion. Der Berührschalter 16 kann durch eine Leuchtanzeige 18 verdeutlicht werden, falls kein Aufdruck auf der Oberseite 13 der Kochfeldplatte 12 vorgesehen ist. Des Weiteren kann mittels der Leuchtanzeige 18 eine bestimmte Information auf anschauliche und deutliche Art wiedergegeben werden.

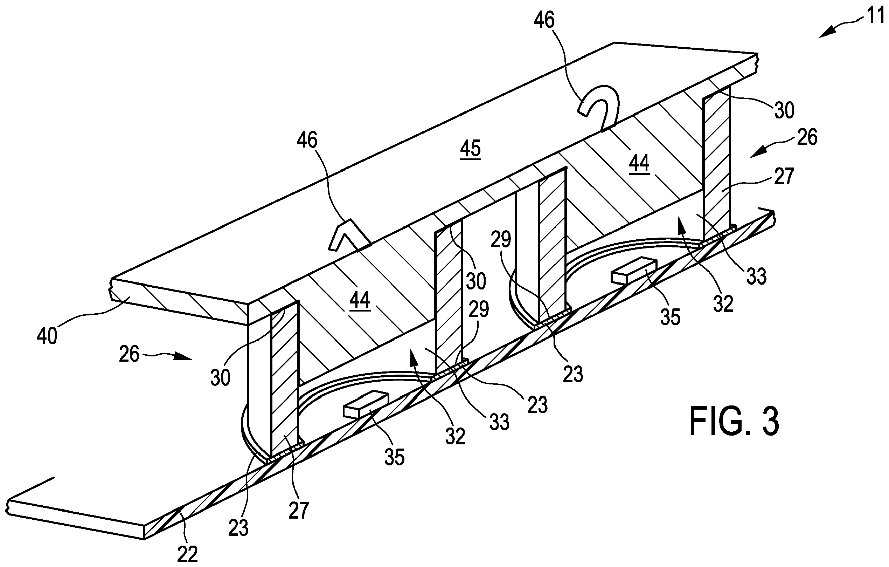

Unter der Kochfeldplatte 12 ist eine Bedieneinrichtung 20 vorgesehen, wobei die Kochfeldplatte 12 der eingangs genannten Bedienblende entspricht, da sie eine Außenseite bzw. Oberseite des Kochfeld 11 als Elektrogerät bildet und insofern auch Bestandteil der Bedieneinrichtung 20 ist. Die Bedieneinrichtung 20 weist eine Leiterplatte 22 auf, auf der sich ein ringförmiges Kontaktfeld 23 mit einer davon abgehenden Leiterbahn 24 befindet. Die Leiterbahn 24 geht zu einer elektrischen Schaltung bzw. Auswertung für den Berührschalter 16. Auf das Kontaktfeld 23 ist ein Sensorelement 26 mit einem rundzylindrischen, innen hohlen Sensorelementkörper 27 aufgesetzt. Der Sensorelementkörper 27 ist ausgebildet wie zuvor beschrieben aus elektrisch leitfähigem Material, das auch eine gewisse Elastizität aufweist. Dessen genaue Ausbildung ist aus den Fig. 2 und 3 noch zu erkennen. Es kann aus elektrisch leitfähigem TPE ausgebildet sein, alternativ auch aus anderem Material.

Der Sensorelementkörper 27 weist eine Unterseite 29 sowie eine Oberseite 30 auf. Die Unterseite 29 kontaktiert das Kontaktfeld 20 elektrisch, wobei sowohl die Kontaktierung als auch eine Befestigung durch Verwendung von sogenanntem Leitkleber verbessert werden können. Sowohl solcher Leitkleber als auch das Sensorelement 26 können automatisch auf die Leiterplatte 22 bestückt werden, beispielsweise mit einem SMD-Bestückungsautomaten.

Der Sensorelementkörper 27 weist einen inneren Hohlraum 32 auf mit einer Innenwand 33. In diesem Hohlraum 32 ist eine LED 35 auf der Leiterplatte 22 befestigt und elektrisch kontaktiert. Vorteilhaft ist es eine SMD-LED. Sie leuchtet, wie durch die Striche angedeutet ist, nach oben um so die Leuchtanzeige 18 zu bilden.

Oberhalb des Sensorelements 26 befindet sich gemäß der Erfindung eine Abdeckung 40, die aus an sich lichtdurchlässigem und elektrisch isolierendem Silikon besteht. Vorteilhaft ist es möglichst transparent. Die Abdeckung 40 weist im Bereich des Sensorelementkörpers 27 bzw. von dessen Oberseite 30 eine ringartige Verdünnung 42 auf. Hier ist die Abdeckung 40 beispielsweise nur noch 1 mm dick. Die sonstige Dicke der Abdeckung 40 kann bei 3 mm bis 4 mm liegen außerhalb des Sensorelementkörpers 27. In den Hohlraum 32 greift die Abdeckung 40 mit einem nach unten ragenden Vorsprung 44 ein. Es ist zu erkennen, dass der Vorsprung 44 den Hohlraum 32 zur Seite hin weitgehend ausfüllt. Der Vorsprung 44 reicht bis kurz vor die LED 35, so dass deren Licht möglichst gut eingekoppelt werden kann und durch den Vorsprung 44 und die Abdeckung 40 nach oben gestrahlt wird als Leuchtanzeige 18. Somit dient der Vorsprung 44 erkennbar einer stabilen Verbindung zwischen Sensorelement 26 und Abdeckung 40. Des Weiteren dient er zum besseren und effektiveren Einkoppeln von Licht.

Gestrichelt dargestellt ist eine alternative Form der Unterseite des Vorsprung 44, die nach unten gewölbt ist. Dadurch ist sie zum einen noch näher an der LED 35 für ein noch besseres Einkoppeln von Licht. Des Weiteren kann durch eine Art Linsenform eine bessere Einkopplung erfolgen. Die entsprechenden Möglichkeiten hierfür sind dem Fachmann bekannt und geläufig.

Aus der Draufsicht auf das Sensorelement 26 gemäß Fig. 2 ist die runde bzw. rundzylindrische Ausgestaltung des Sensorelementkörpers 27 sowie des Hohlraum 32 zu ersehen. In dessen Mitte ist eben auf die Leiterplatte 22 die LED 35 aufgesetzt.

Aus der geschnittenen Schrägdarstellung der Fig. 3 ohne die Kochfeldplatte ist noch zu ersehen, dass die Abdeckung 40 auf ihrer Oberseite eine Beschichtung 45 aufweist. Diese Beschichtung 45 ist vollflächig und dient dazu, eine ungewollte Leuchterscheinung nach oben zu vermeiden. In der Beschichtung 45 sind nämlich oberhalb der Sensorelemente 26 Symbol-Ausnehmungen 46 vorgesehen, links eine "1" und rechts eine "2". Bei den Symbol-Ausnehmungen 46 ist die lichtundurchlässige Beschichtung 45 entfernt, sodass hier Licht von der jeweiligen LED 35 gut nach oben hindurch strahlen kann für eine entsprechende Leuchtanzeige, wie in Fig. 1 dargestellt.

Bei dieser leichten Abwandlung der Fig. 3 weist die gesamte Abdeckung 40 nur zwei unterschiedliche Dicken auf, nämlich eine sozusagen normale Dicke im allergrößten Bereich und die deutlich größere Dicke an den nach unten ragenden Vorsprüngen 44. Diese Vorsprünge 44 greifen jeweils in den inneren Hohlraum 32 der Sensorelementkörper 27 ein.

Eine deutlichere Abwandlung, die nicht zu der Erfindung gehört, ist in der Fig. 4 dargestellt. Dieses Kochfeld 111 weist eine Kochfeldplatte 112 samt Oberseite 113 und Unterseite 114 auf, wobei an der Kochfeldplatte 112 eine Berührfläche 115 und ein kapazitiver Berührschalter 116 gebildet sind. An der Unterseite 114 ist eine Abdeckung 140 vorgesehen, welche durchgehend gleichbleibende Dicke aufweist. Die Abdeckung 140 ist hier relativ dünn dargestellt, beispielsweise nur mit 1 mm bis 2 mm Dicke. Die Abdeckung 140 weist ansonsten auf ihrer Oberseite eine lichtundurchlässige Beschichtung mit entsprechenden Symbol-Ausnehmungen auf, wie es die Fig. 3 zeigt, um jeweils eine entsprechend gestaltete Leuchtanzeige 118 zu ermöglichen.

Ein Sensorelement 126 mit einem Sensorelementkörper 127 einer Bedieneinrichtung 120 liegt mit seiner Oberseite 31 an der Unterseite der Abdeckung 140 an. Eine Unterseite 129 des Sensorelementkörpers 127 liegt wiederum auf einem ringförmigen Kontaktfeld 123 einer Leiterplatte 122 auf, über eine davon abgehende Leiterbahn 124 wird ein elektrischer Kontakt hergestellt. Auch der Sensorelementkörper 127 ist ein runder Hohlzylinder mit einem Innenraum 132, der hier allerdings frei bzw. leer ist, da kein Teil der Abdeckung 140 hinein greift. Eine Innenwand 133 des Sensorelementkörpers 127 ist mit einer reflektierenden Beschichtung 137 versehen, die beispielsweise eine glänzende weiße Farbe, Folie oder ein entsprechend dünn ausgebildetes Kunststoffteil sein kann. Diese Beschichtung 137 weist aufgrund seiner reflektierenden Eigenschaften den Vorteil auf, dass von der LED 135 ausgesandtes Licht nach oben reflektiert wird und damit durch die Abdeckung 140 und deren Symbol-Ausnehmungen hindurch eine Leuchtanzeige 118 erzeugt wird.

## Patentansprüche

1. Bedieneinrichtung (20) für ein Elektrogerät (11), wobei die Bedieneinrichtung (20) aufweist:
- einen Bauteilträger (22) und eine Bedienblende (12), die mit Abstand zueinander angeordnet sind,
- mindestens einen kapazitiven Berührungsschalter (16) mit einer Berührfläche (15) an der Bedienblende (12),
- elektrisch leitfähige Sensorelementkörper (27), die auf den Bauteilträger (22) aufgesetzt sind und elektrisch daran kontaktiert sind,
- eine elektrisch isolierende Abdeckung (40), die oben auf den Sensorelementkörpern (27) angeordnet ist und die die Sensorelementkörper (27) in der Projektion von oben vollständig überdeckt, wobei die Abdeckung (40) mit ihrer Oberseite zu einer Unterseite (14) der Bedienblende (12) hin angeordnet ist und an der Unterseite (14) der Bedienblende (12) anliegt,
wobei:
- jeder Sensorelementkörper (27) auf ein Kontaktfeld (23) auf dem Bauteilträger (22) aufgesetzt ist zur elektrischen Kontaktierung,
- die Sensorelementkörper (27) mit dem Bauteilträger (22) verklebt sind,
- auf dem Bauteilträger (22) mehrere gleiche Sensorelementkörper (27) angeordnet sind zur Bildung von kapazitiven Berührungsschaltern (16),
- jeder Sensorelementkörper (27) ein Hohlkörper ist mit einem inneren Hohlraum (32), der sich als Durchgangsöffnung in Richtung von dem Bauteilträger (22) zu der Bedienblende (12) hin erstreckt, wobei in dem inneren Hohlraum (32) auf dem Bauteilträger (22) mindestens ein Leuchtmittel (35) angeordnet ist,
- die Abdeckung (12) über mehreren Sensorelementkörpern (27) angeordnet ist,
- die Abdeckung (40) mit einem Vorsprung (44) nach unten in den inneren Hohlraum (32) des Sensorelementkörpers (27) hineinreicht,
- die Abdeckung (12) lichtdurchlässig ist zumindest in dem Bereich über dem inneren Hohlraum (32).

2. Bedieneinrichtung nach Anspruch 1, **dadurch gekennzeichnet, dass** der Sensorelementkörper (27) mittels elektrisch leitfähigem Leitkleber mit dem Kontaktfeld (23) verklebt ist.

3. Bedieneinrichtung nach Anspruch 1 oder 2, **dadurch gekennzeichnet, dass** die Sensorelementkörper (27) aus Vollmaterial bestehen, das elektrisch leitfähig ist, insbesondere ohne Lufteinschlüsse, wobei die Sensorelementkörper (27) einen spezifischen elektrischen Widerstand aufweisen.

4. Bedieneinrichtung nach einem der vorhergehenden Ansprüche, **dadurch gekennzeichnet, dass** die Sensorelementkörper (27) identisch sind.

5. Bedieneinrichtung nach einem der vorhergehenden Ansprüche, **dadurch gekennzeichnet, dass** das Leuchtmittel (35) eine SMD-LED ist.

6. Bedieneinrichtung nach einem der vorhergehenden Ansprüche, **dadurch gekennzeichnet, dass** die Abdeckung (40) elektrisch isolierend beschichtet ist und/oder aus elektrisch isolierendem Material besteht.

7. Bedieneinrichtung nach einem der vorhergehenden Ansprüche, **dadurch gekennzeichnet, dass** die Abdeckung (40) zwischen 1 mm und 10 mm dick ist, vorzugsweise zwischen 1 mm und 4 mm dick ist an der dünnsten Stelle.

8. Bedieneinrichtung nach einem der vorhergehenden Ansprüche, **dadurch gekennzeichnet, dass** die Abdeckung (40) insgesamt aus lichtdurchlässigem Material besteht, insbesondere aus elastischem lichtdurchlässigem Material wie Silikon.

9. Bedieneinrichtung nach einem der vorhergehenden Ansprüche, **dadurch gekennzeichnet, dass** die Abdeckung (40) mit einer lichtundurchlässigen Beschichtung (45) versehen ist, insbesondere an der Oberseite der Abdeckung (40), die zu der Unterseite (14) der Bedienblende (12) hin weist, wobei vorzugsweise die lichtundurchlässige Beschichtung (45) eine Ausnehmung (46) in Form von Symbolen, Zeichen oder Buchstaben oberhalb des inneren Hohlraums (32) aufweist, damit Licht von den Leuchtmitteln (35) durch die Abdeckung (40) hindurchstrahlen kann um eine der Form des Symbols oder des Buchstabens entsprechende Leuchterscheinung an der Bedienblende (12) zu bewirken.

10. Bedieneinrichtung nach einem der vorhergehenden Ansprüche, **dadurch gekennzeichnet, dass** der Vorsprung (44) der Abdeckung (40) nach unten eine Form korrespondierend zu der Form bzw. dem Querschnitt des inneren Hohlraums (32) aufweist und insbesondere bis kurz vor ein Leuchtmittel (35) in dem inneren Hohlraum (32) reicht.

11. Bedieneinrichtung nach einem der vorhergehenden Ansprüche, **dadurch gekennzeichnet, dass** eine einzige Abdeckung (40) zusammenhängend über sämtlichen Sensorelementkörpern (27) angeordnet ist.

12. Bedieneinrichtung nach einem der vorhergehenden Ansprüche, **dadurch gekennzeichnet, dass** die Abdeckung (40) in der Draufsicht eine rechteckige Form aufweist.

13. Bedieneinrichtung nach einem der vorhergehenden Ansprüche, **dadurch gekennzeichnet, dass** eine Höhe der Sensorelementkörper (27) zwischen 3 mm und 20 mm beträgt.

14. Elektrogerät (11) mit einer Bedieneinrichtung (20) nach einem der vorhergehenden Ansprüche, **dadurch gekennzeichnet, dass** die Bedienblende (12) eine Vorderfront oder eine Abdeckung bzw. eine Außenseite oder eine Außenwand des Elektrogeräts (11) zumindest teilweise bildet oder ist, wobei vorzugsweise die Bedienblende (12) undurchbrochen ist bzw. keine Durchbrüche aufweist.

15. Elektrogerät nach Anspruch 14, **dadurch gekennzeichnet, dass** das Elektrogerät ein Kochfeld (11) mit einer Kochfeldplatte (12) ist, wobei ein Teil der Kochfeldplatte (12) die Bedienblende bildet, wobei vorzugsweise die Oberseite der Abdeckung (40) an der Unterseite (14) der Kochfeldplatte (12) als Bedienblende anliegt und die Berührflächen (15) an der Oberseite (13) der Kochfeldplatte (12) gebildet sind.

## Claims

1. An operating device (20) for an electrical appliance (11), the operating device (20) having
- a component carrier (22) and an operating panel (12), which are arranged at a distance from one another,
- at least one capacitive touch switch (16) with a contact surface (15) on the operating panel (12),
- electrically conductive sensor element bodies (27), which are placed on the component carrier (22) and are electrically contacted thereto,
- an electrically insulating cover (40), which is arranged on top of the sensor element bodies (27) and which completely covers the sensor element bodies (27) in the projection from above, wherein the cover (40) is arranged with its upper side towards an underside (14) of the operating panel (12) and rests against the underside (14) of the operating panel (12),
wherein:
- each sensor element body (27) is placed on a contact field (23) on the component carrier (22) for electrical contacting,
- the sensor element bodies (27) are bonded to the component carrier (22),
- a plurality of identical sensor element bodies (27) are arranged on the component carrier (22) to form capacitive contact switches (16),
- each sensor element body (27) is a hollow body with an inner cavity (32) which extends as a through-opening in the direction from the component carrier (22) to the operating panel (12), at least one illuminating means (35) being arranged in the inner cavity (32) on the component carrier (22),
- the cover (40) is arranged over a plurality of sensor element bodies (27),
- the cover (40) extends with a projection (44) downwards into the inner cavity (32) of the sensor element body (27),
- the cover (40) is translucent at least in the area above the inner cavity (32).

2. Operating device according to claim 1, **characterised in that** the sensor element body (27) is bonded to the contact field (23) by means of electrically conductive conductive adhesive.

3. Operating device according to claim 1 or 2, **characterised in that** the sensor element bodies (27) consist of solid material which is electrically conductive, in particular without air inclusions, the sensor element bodies (27) having a specific electrical resistance.

4. Operating device according to one of the preceding claims, **characterised in that** the sensor element bodies (27) are identical.

5. Operating device according to one of the preceding claims, **characterised in that** the illuminating means (35) is an SMD LED.

6. Operating device according to one of the preceding claims, **characterised in that** the cover (40) has an electrically insulating coating and/or is made of electrically insulating material.

7. Operating device according to one of the preceding claims, **characterised in that** the cover (40) is between 1 mm and 10 mm thick, preferably between 1 mm and 4 mm thick at the thinnest point.

8. Operating device according to one of the preceding claims, **characterised in that** the cover (40) as a whole consists of translucent material, in particular of elastic translucent material such as silicone.

9. Operating device according to one of the preceding claims, **characterised in that** the cover (40) is provided with an opaque coating (45), in particular on the upper side of the cover (40), which faces the underside (14) of the operating panel (12), wherein preferably the opaque coating (45) has a recess (46) in the form of symbols, characters or letters above the inner cavity (32), so that light from the illuminating means (35) can shine through the cover (40) in order to produce an illuminated appearance on the operating panel (12) corresponding to the shape of the symbol or the letter.

10. Operating device according to one of the preceding claims, **characterised in that** the projection (44) of the cover (40) has a downward shape corresponding to the shape or the cross-section of the inner cavity (32) and, in particular, extends to just in front of an illuminating means (35) in the inner cavity (32).

11. Operating device according to one of the preceding claims, **characterised in that** a single cover (40) is arranged contiguously over all sensor element bodies (27).

12. Operating device according to one of the preceding claims, **characterised in that** the cover (40) has a rectangular shape in plan view.

13. Operating device according to one of the preceding claims, **characterised in that** a height of the sensor element bodies (27) is between 3 mm and 20 mm.

14. Electrical appliance (11) having an operating device (20) according to one of the preceding claims, **characterised in that** the operating panel (12) forms or is at least partially forms a front panel or a cover or an outer side or an outer wall of the electrical appliance (11), the operating panel (12) preferably being unperforated or having no perforations.

15. Electrical appliance according to claim 14, **characterised in that** the electrical appliance is a hob (11) with a hob plate (12), wherein a part of the hob plate (12) forms the operating panel, wherein preferably the upper side of the cover (40) rests against the underside (14) of the hob plate (12) as the operating panel and the contact surfaces (15) are formed on the upper side (13) of the hob plate (12).

## Revendications

1. Dispositif de commande (20) pour un appareil électrique (11), le dispositif de commande (20) présentant :
- un support de composants (22) et un panneau de commande (12), qui sont disposés à distance l'un de l'autre,
- au moins un commutateur tactile capacitif (16) avec une surface de contact (15) sur le panneau de commande (12),
- des corps d'éléments de capteur (27), qui sont placés sur le support de composants (22) et sont en contact électrique avec celui-ci,
- un couvercle (40) électriquement isolant, qui est disposé en haut sur les corps d'éléments de capteur (27) et qui recouvre complètement les corps d'éléments de capteur (27) en projection depuis le haut, le couvercle (40) étant disposé avec sa face supérieure vers une face inférieure (14) du panneau de commande (12) et s'appliquant contre la face inférieure (14) du panneau de commande (12),
où:
- chaque corps d'élément de capteur (27) est placé sur un champ de contact (23) sur le support de composants (22) pour la mise en contact électrique,
- les corps d'éléments de capteur (27) sont collés sur le support de composants (22),
- plusieurs corps d'éléments de capteur (27) identiques sont disposés sur le support de composants (22) pour former des commutateurs de contact capacitifs (16),
- chaque corps d'élément de capteur (27) est un corps creux avec un espace creux intérieur (32) qui s'étend en tant qu'ouverture de passage en direction du support de composants (22) vers le panneau de commande (12), au moins un moyen d'éclairage (35) étant disposé dans l'espace creux intérieur (32) sur le support de composants (22),
- le couvercle (12) est disposé au-dessus de plusieurs corps d'éléments de capteur (27),
- le couvercle (40) pénètre avec une saillie (44) vers le bas dans la cavité intérieure (32) du corps d'élément de capteur (27),
- le couvercle (12) laisse passer la lumière au moins dans la zone située au-dessus de la cavité intérieure (32).

2. Dispositif de commande selon la revendication 1, **caractérisé en ce que** le corps de l'élément de capteur (27) est collé au champ de contact (23) au moyen d'une colle conductrice électriquement conductrice.

3. Dispositif de commande selon la revendication 1 ou 2, **caractérisé en ce que** les corps d'élément de capteur (27) sont constitués d'un matériau plein qui est électriquement conducteur, en particulier sans inclusions d'air, les corps d'élément de capteur (27) présentant une résistance électrique spécifique.

4. Dispositif de commande selon l'une des revendications précédentes, **caractérisé en ce que** les corps des éléments de capteur (27) sont identiques.

5. Dispositif de commande selon l'une des revendications précédentes, **caractérisé en ce que** l'élément lumineux (35) est une LED SMD.

6. Dispositif de commande selon l'une des revendications précédentes, **caractérisé en ce que** le couvercle (40) est revêtu d'un matériau électriquement isolant et/ou est constitué d'un matériau électriquement isolant.

7. Dispositif de commande selon l'une des revendications précédentes, **caractérisé en ce que** le couvercle (40) a une épaisseur comprise entre 1 mm et 10 mm, de préférence entre 1 mm et 4 mm à l'endroit le plus mince.

8. Dispositif de commande selon l'une des revendications précédentes, **caractérisé en ce que** le couvercle (40) est globalement constitué d'un matériau translucide, notamment d'un matériau élastique translucide tel que du silicone.

9. Dispositif de commande selon l'une des revendications précédentes, **caractérisé en ce que** le couvercle (40) est pourvu d'un revêtement opaque (45), notamment sur la face supérieure du couvercle (40) qui est tournée vers la face inférieure (14) du panneau de commande (12), de préférence, le revêtement opaque (45) comporte un évidement (46) en forme de symbole, de caractère ou de lettre au-dessus de la cavité intérieure (32) pour permettre à la lumière provenant des moyens d'éclairage (35) de traverser le couvercle (40) afin de produire un phénomène d'éclairage sur le panneau de commande (12) correspondant à la forme du symbole ou de la lettre.

10. Dispositif de commande selon l'une des revendications précédentes, **caractérisé en ce que** la saillie (44) du couvercle (40) présente vers le bas une forme correspondant à la forme ou à la section transversale de la cavité intérieure (32) et s'étend en particulier juste devant un moyen lumineux (35) dans la cavité intérieure (32).

11. Dispositif de commande selon l'une des revendications précédentes, **caractérisé en ce qu'**un seul couvercle (40) est disposé de manière continue sur tous les corps des éléments de capteur (27).

12. Dispositif de commande selon l'une des revendications précédentes, **caractérisé en ce que** le couvercle (40) présente une forme rectangulaire en vue de dessus.

13. Dispositif de commande selon l'une des revendications précédentes, **caractérisé en ce que** la hauteur des corps des éléments de capteur (27) est comprise entre 3 mm et 20 mm.

14. Appareil électrique (11) avec un dispositif de commande (20) selon l'une des revendications précédentes, **caractérisé en ce que** le panneau de commande (12) forme ou est au moins partiellement une façade avant ou un couvercle ou une face extérieure ou une paroi extérieure de l'appareil électrique (11), le panneau de commande (12) étant de préférence non ajouré ou ne présentant pas d'ajours.

15. Appareil électrique selon la revendication 14, **caractérisé en ce que** l'appareil électrique est une table de cuisson (11) avec une plaque de cuisson (12), une partie de la plaque de cuisson (12) formant le panneau de commande, la face supérieure du couvercle (40) s'appliquant de préférence contre la face inférieure (14) de la plaque de cuisson (12) comme panneau de commande et les surfaces de contact (15) étant formées sur la face supérieure (13) de la plaque de cuisson (12).
